# EUROPÄISCHE PATENTSCHRIFT

(11) **EP 1 753 679 B1**
(45) Veröffentlichungstag und Bekanntmachung des Hinweises auf die Patenterteilung: **04.08.2010**
(21) Anmeldenummer: 05742263.6
(22) Anmeldetag: 27.05.2005
(51) Int. Cl.: B65G 49/06, C03B 33/03, C03B 33/08

(54) **TISCH ZUR AUFNAHME EINES WERKSTÜCKS SOWIE VERFAHREN ZUR BEARBEITUNG EINES WERKSTÜCKS AUF EINEM SOLCHEN**
TABLE USED TO RECEIVE A WORKPIECE AND METHOD FOR TREATING A WORKPIECE ON SAID TYPE OF TABLE
ETABLI DE RECEPTION D'UNE PIECE ET PROCEDE DE TRAITEMENT D'UNE PIECE SUR UN TEL ETABLI

(30) Priorität: 03.06.2004 CH 935042004
(43) Veröffentlichungstag der Anmeldung: 21.02.2007
(60) Teilanmeldung: 10005381.8
(73) Patentinhaber: Oerlikon Solar IP AG, Trübbach, 9477 Trübbach (CH)
(72) Erfinder: GRUNDMÜLLER, Richard, 80636 München (DE); MEIER, Johannes, CH-2035 Corcelles (CH); BÜCHEL, Arthur, FL-9491 Ruggel (LI)
(74) Vertreter: Wagner, Wolfgang Heribert
(86) Internationale Anmeldenummer: PCT/CH2005/000300
(87) Internationale Veröffentlichungsnummer: WO 2005/118440

(56) Entgegenhaltungen:
- EP-A- 1 405 832
- WO-A-03/086917
- WO-A-2004/035493
- DE-A1- 19 620 234
- FR-A- 1 400 501
- GB-A- 1 308 632
- GB-A- 1 420 022
- JP-A- 7 010 266
- JP-A- 8 143 323
- US-A- 3 449 102
- US-A- 3 607 198
- US-A- 5 003 729
- US-A- 5 078 775
- US-A- 5 762 674
- US-B1- 6 463 762

## Beschreibung

### Technisches Gebiet

Die Erfindung betrifft einen Tisch zur Aufnahme eines Werkstücks gemäss dem Oberbegriff des Anspruchs 1 sowie ein Verfahren zur Bearbeitung eines Werkstücks auf einem erfindungsgemässen Tisch. Derartige Tische werden z.B. für die Bearbeitung von plattenförmigen Werkstücken wie Glasplatten mittels Lasern, z.B. zum Laserscriben oder Schneiden eingesetzt.

### Stand der Technik

Es ist bekannt, Glasplatten und ähnliche Werkstücke an zwei gegenüberliegenden Rändern einzuspannen und, gewöhnlich von oben, zu bearbeiten. Bei grossflächigen dünnen Werkstücken entsteht dabei jedoch stets ein Durchhang, der den Abstand zwischen Werkstück und Bearbeitungsvorrichtung in nicht völlig kontrollierbarer Weise beeinflusst, was bei hohen Genauigkeitsanforderungen mindestens weitere Vorkehrungen erforderlich macht, u.U. aber auch eine ausreichende Präzision bei der Bearbeitung nicht zulässt.

Demgegenüber ist es möglich, das Werkstück auf eine durchgehende ebene Stützfläche aufzulegen und so Durchhang weitgehend zu verhindern. Wegen der unvermeidlichen Rauhigkeit der Stützfläche können jedoch lokale Deformationen des Werkstücks, die zwar wesentlich geringfügiger, aber z.B. bei der Herstellung von Strukturen im Mikrometer- und Submikrometerbereich immer noch störend sind, auch in diesem Fall nicht vollständig ausgeschlossen werden. Ausserdem besteht ein nicht zu vernachlässigendes Risiko, dass das Werkstück durch den direkten Kontakt mit der Stützfläche verkratzt oder seine Oberfläche auf andere Weise beschädigt wird. Dies kann vor allem bei der Bearbeitung von Substraten für die Halbleiterindustrie wie grossflächigen Wafern zu Ausschuss führen. Es wurde daher schon vorgeschlagen, Tische zur Aufnahme von Werkstücken mit Ausströmöffnungen zur Herstellung eines Gaspolsters zu versehen.

So ist aus EP 1 405 832 A1 ein gattungsgemässer Tisch bekannt, bei dem an einem zwei Abschnitte der Stützfläche trennenden Spalt jeweils eine Schneidvorrichtung zum Schneiden von Glasplatten angeordnet ist. Eine Vorschubeinrichtung für die Glasplatten besteht aus seitlich der Abschnitte angeordneten, nicht gestützten Förderbändern und an denselben angebrachten Saugnäpfen. Mit dieser Vorschubeinrichtung ist eine hochpräzise Führung von Werkstücken nicht möglich.

WO 03/086 917 A1 zeigt eine Anlage zur Ueberprüfung von Werkstücken mit einer Stützfläche, die aus mehren aufeinanderfolgenden, durch Spalte getrennten Abschnitten besteht. Diese sind beidseits von Linearführungen überbrückt, längs welchen jeweils Arme verschiebbar sind. Letztere tragen Saugnäpfe, die zur Ausrichtung des Werkstücks vor der Ueberprüfung desselben quer zur Vorschubrichtung verschiebbar sind. Die Ueberprüfung des Werkstücks erfolgt dann von oben. Für eine präzise lineare Bewegung des Werkstücks in Vorschubrichtung sind die seitlich verschiebbaren Saugnäpfe nicht optimal.

### Darstellung der Erfindung

Der Erfindung liegt die Aufgabe zu Grunde, einen Tisch anzugeben, der eine hochgenaue Bearbeitung des Werkstücks durch Laser oder anderer Bearbeitungsvorrichtungen ermöglicht. Diese Aufgabe wird durch die Merkmale im Kennzeichen des Anspruchs 1 gelöst. Ausserdem soll ein geeignetes Verfahren zur Bearbeitung eines Werkstücks auf einem erfindungsgemässen Tisch angegeben werden. Diese Aufgabe wird durch die Merkmale des Anspruchs 15 gelöst.

Die Aufnahme ermöglicht eine präzise lineare Bewegung von Werkstücken verschiedener Längen längs einer konstanten Vorschubrichtung und damit eine entsprechend genaue Bearbeitung. Damit können etwa Muster mit einer Laser-Bearbeitungsvorrichtung erzeugt werden, obwohl dies eine Genauigkeit bis hinab zu einigen Mikrometern erfordern kann.

Durch die Luftkissenlagerung des Werkstücks, der Platte bzw. der Glasplatte hat die vorliegende Erfindung den grossen Vorteil, dass beim Bearbeiten des plattenförmigen Werkstücks dessen Unterseite nicht mit der Tischoberseite in Berührung kommt, wodurch eine unerwünschte Verschmutzung bzw. ein Verkratzen oder eine Beschädigung der Plattenunterseite, z.B. durch die Tischoberfläche oder Partikel vermieden wird. Ferner kann durch die Luftkissenlagerung des Werkstücks ein Durchhängen oder Durchbiegen des Substrats vermieden werden. Durch Einstellen der Druckverhältnisse kann darüber das Höhenniveau in gewissen Grenzen geregelt werden, was bei manchen der Behandlungsschritte von Vorteil ist. Darüber hinaus ermöglicht das beschriebene Luft- oder Gaskissen einen (quasi-)reibungsfreien Transport des Werkstückes auf der Tischplatte.

Als Werkstücke sind hier insbesondere scheibenförmige oder plattenförmige Werkstücke, z.B. Glasscheiben, Glassubstrate, Keramikplatten, Wafer aus Halbleitermaterial wie Silizium in Betracht zu ziehen. Diese Platten können Flächen von z.B. 2 m² und darüber erreichen und gleichzeitig eine Stärke von z.B. nur 1 mm und kleiner haben, also großflächig und dünn sein, und sie bestehen in der Regel aus einem spröden Material wie Glas oder Keramik.

Bevorzugt hat die Vorrichtung der Erfindung einen Tisch oder eine Tischplatte, die aus mindestens zwei Segmenten aufgebaut ist. Die dem Werkstück zugewandte Oberfläche eines Segmentes weist mehrere äquidistant zueinander sich erstreckende und in Reihen angeordnete Austrittsöffnungen bzw. Austrittskanäle auf für das druckbeaufschlagte Gas von der Druckeinrichtung, die mit der Druckeinrichtung fluidgängig gekoppelt sind. Die Austrittsöffnungen des druckbeaufschlagten Gases sind über im wesentlichen die gesamte Tischoberseite gleichmäßig verteilt, wodurch ein gleichmäßiger Druck auf das luftkissengelagerte Werkstück erzeugt wird und somit ein unerwünschtes Durchbiegen der Werkstückplatte vermieden wird.

Die Vorrichtung der Erfindung hat bevorzugt eine Saugeinrichtung zum Ansaugen des druckbeaufschlagten Gases von der dem Werkstück zugewandten Oberseite des Tisches oder der Tischplatte. Dies hat den Vorteil, dass über die Druckdifferenz zwischen der Druckseite mit hohem Druck und der Ansaugseite mit zumindest kleinerem Druck der herrschende Fluiddruck im tragenden Gaskissen kontrolliert eingestellt werden kann. Hierdurch kann der Druck im Gaskissen bzw. Luftkissen auch derart eingestellt werden, dass das scheibenförmige Werkstück die vorgegebene Bearbeitungshöhe für die Bearbeitung einhält.

Bevorzugt hat der Tisch (bzw. sinngleich angewandt ein Segment) an seiner dem Werkstück zugewandten Oberfläche mehrere über die Oberseite des Tisches oder der Tischplatte hinweg gleichmäßig verteilte Ansaugöffnungen, die mit der Ansaugeinrichtung fluidgängig gekoppelt sind. Hierdurch wird eine gleichmäßiges Ansaugen über die gesamte Tisch- bzw. Segmentoberseite gesehen ermöglicht und somit auch eine gleichmäßig über die gesamte Tisch- bzw. Segmentfläche verteilte und auftretende Druckverteilung auf das Werkstück erreicht. Der Tisch der Erfindung hat bevorzugt in oder an seiner dem Werkstück zugewandten Oberseite mehrere äquidistant aufeinanderfolgend in Längsrichtung des Tisches sich erstreckende Ansaugkanäle, Ansaugrillen oder Vertiefungen als Ansaugöffnungen, die sich - bevorzugt - jeweils im wesentlichen über die gesamte Breite des Tisches ununterbrochen erstrecken, wodurch die gleichmäßig auf die Fläche bezogene Ansaugung von Fluid oder Luft verbessert wird.

Die Ansaugkanäle können einen schlangenförmigen, zickzackförmigen, sägezahnförmigen und/oder mäanderförmigen Ansaugquerschnitt haben. Der Ansaugquerschnitt der Ansaugöffnung kann jedoch auch rund, z.B. kreisförmig, oder eckig, z.B. rechteckig, sein.

Bevorzugt ist der Tisch bzw. die Tischplatte des Tisches derart unterteilt, dass Segmente (entsprechend) Tischplattenhälften koplanar, stirnseitig unter Ausbildung eines Spaltes, einer Vertiefung bzw. eines Zwischenraums zwischen den Segmenten bereitgestellt sind. Im Spalt ist eine Behandlungsvorrichtung anbringbar, die je nach Aufgabe der Vorrichtung eine Mess, Prüf- oder Bearbeitungsvorrichtung sein kann. Auch kann oberhalb des Tisches, über dem Substrat eine weitere Bearbeitungsvorrichtung angebracht werden, räumlich versetzt oder aber in einer Anordnung, die ein gleichzeitiges Behandeln desselben Substratgebietes von oben und unten erlaubt. Dies kann wiederum, je nach Zweckbestimmung gleichzeitiges Bearbeiten, aber auch Bearbeiten und Messen sein, was z. B. eine Regelung des Bearbeitungsvorgangs erlaubt.

So wird beispielsweise im Fall von Laserbearbeitung durch den Spalt zwischen den Segmenten vorteilhaft eine gleichzeitige, beidseitige Bearbeitung von Platten mittels Laserstrahlung ermöglicht.

### Kurze Beschreibung der Zeichnungen

Im folgenden wird die Erfindung anhand von Figuren, welche lediglich ein Ausführungsbeispiel darstellen, näher erläutert. Es zeigen
- Fig. 1: eine schematische Ansicht einer beispielhaften Ausführungsform des erfindungsgemässen Tischs,
- Fig. 2: eine perspektivische Ansicht, die den Tisch der Ausführungsform der Vorrichtung der Erfindung von Fig. 1 herausgetrennt zeigt,
- Fig. 3: eine Draufsicht auf eine ausgeschnittene Öffnungsgruppe, die in der Ausführungsform der Vorrichtung der Erfindung in Fig. 2 verwendet wird und
- Fig. 4: eine Draufsicht auf eine Aufnahme für ein Werkstück und eine Linearführung für dieselbe an der Oberseite des erfindungsgemässen Tisches.

### Wege zur Ausführung der Erfindung

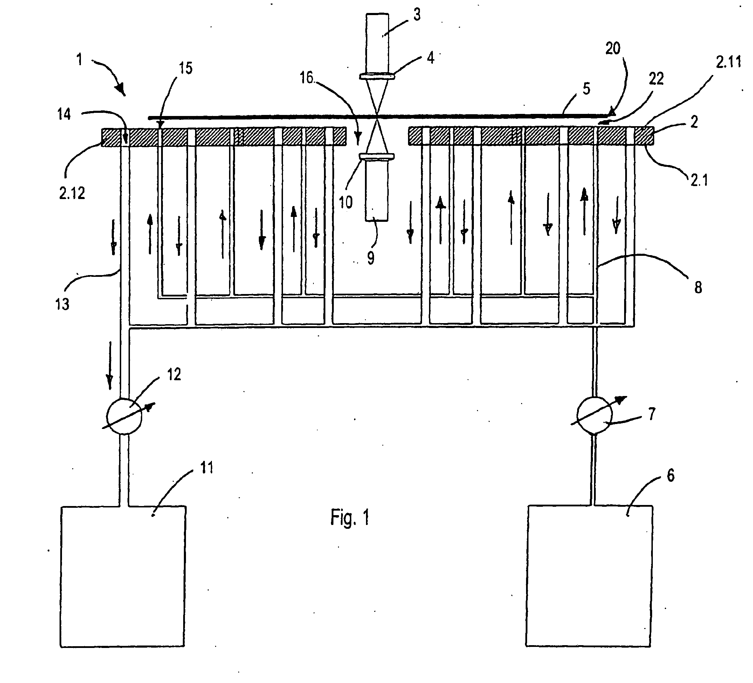

In Fig. 1 ist eine Vorrichtung 1 dargestellt mit einem erfindungsgemässen Tisch 2, als Bearbeitungsvorrichtung ist schematisch eine Lasereinrichtung gezeigt, eine Strömungserzeugungseinrichtung mit einer Abzugeinrichtung 11 und einer Druckerzeugungseinrichtung 6, die ein druckbeaufschlagtes Fluid, z.B. Stickstoff oder ein sonstiges Gas bzw. Gasgemisch, hier Luft abgibt. Das scheibenförmige Werkstück 5 ist z.B. eine Glasplatte, eine Keramikplatte oder eine andere Platte aus sprödem Substratmaterial, die mittels der Lasereinrichtung bearbeitet werden soll. In der vorliegenden, beispielhaften und bevorzugten Ausführungsform der Erfindung gemäß Fig. 1 ist das scheibenförmige Werkstück 5 eine Substratkeramikplatte oder eine Glassubstratplatte.

Der Tisch 2 besteht im wesentlichen aus einer Tischplatte 2.1, die eine nach oben weisende Stützfläche bildet. Sie umfasst zwei Segmente, die als zwei gleich große rechteckige Hälften 2.11 und 2.12 ausgebildet sind. Die Oberseiten 17.1 und 17.2 der Segmente 2.11, 2.12 bilden jeweils einen Flächenabschnitt der Stützfläche des Tisches 2, der dem scheibenförmigen Werkstück 5 zugewandt ist, und haben an ihrer Oberfläche vielzählige Ausströmöffnungen 15, aus denen druckbeaufschlagte Luft ausströmt, und vielzählige Abzugsöffnungen 14, über die druckbeaufschlagte Luft von den Oberseiten 17.1, 17.2 der Plattenhälften 2.11 und 2.12 zumindest teilweise angesaugt wird.

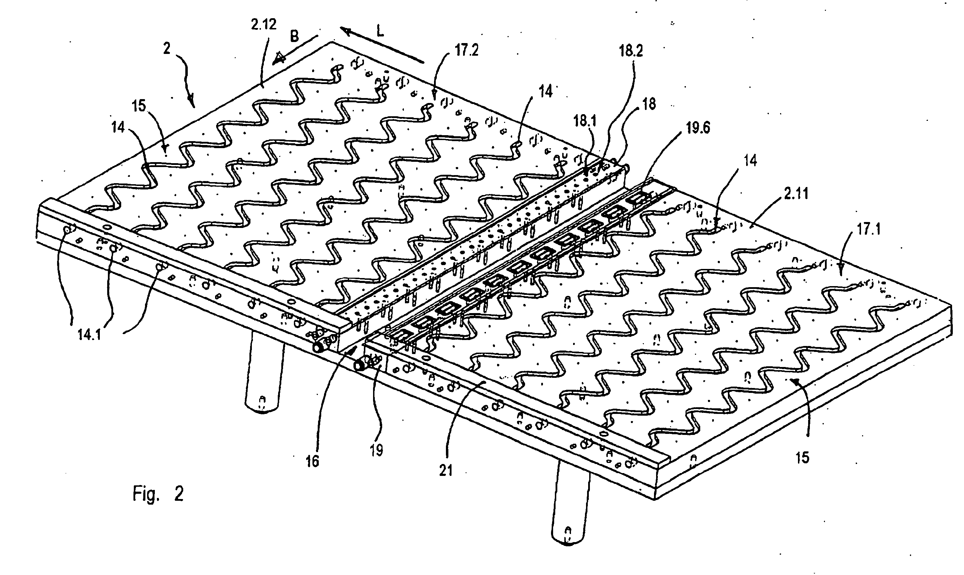

Die Abzugsöffnungen 14 sind an der Oberseite 17.2 der Plattenhälfte 2.12 und an der Oberseite 17.1 der Plattenhälfte 2.11 als an der Oberseite offene Rillen, Vertiefungen bzw. Kanäle ausgebildet, die in der Draufsicht jeweils einen zickzack- oder schlangenförmigen Abzugquerschnitt im wesentlichen über die gesamte Breite B der Tischplattenhälften 2.12 bzw. 2.11 ununterbrochen haben. So sind in Fig. 2 sechs Abzugsöffnungen 14 mit gleicher Form gezeigt, die in Vorschubrichtung des Werkstücks 5, also in Längsrichtung L des Tisches 2 gesehen, äquidistant hintereinander ausgebildet sind. Auch die Tischplattenhälfte 2.11 hat sechs äquidistant hintereinander ausgebildete, schlangenförmige Abzugsöffnungen 14. Die Abzugsöffnungen 14 sind im wesentlichen über die gesamte Oberseite 17.1 bzw. 17.2 der Tischplattenhälften 2.12 und 2.11 derart gleichmäßig verteilt, dass ein gleichmäßiges Abziehen des gasförmigen Mediums über die Tischplattenoberfläche hinweg sichergestellt werden kann. Zwischen den Windungen der schlan-genförmigen Abzugsöffnungen 14 sind Ausströmöffnungen 15 bzw. Austrittsdüsen mit einem kreisförmigen Austrittsquerschnitt äquidistant hintereinanderfolgend sowohl in der Längsrichtung L als auch in der Breitenrichtung B der Tischplatte 2.1 gesehen ausgebildet. Ihr Durchmesser liegt vorzugsweise zwischen 0,1 mm und 2 mm, kann aber je nach Anwendung zwischen 0.05 mm und 10 mm betragen. Die Ausströmöffnungen 15 sind in Fig. 2 jeweils als Punkt zu sehen und haben somit eine jeweils erheblich geringeren Öffnungsquerschnitt im Vergleich zu den rillenartigen Abzugsöffnungen 14, die einen relativ größeren Abzugsquerschnitt bereitstellen. Auch die Ausströmöffnungen 15 sind über die gesamte Tischplatte 2.1, also die Tischplattenhälfte 2.11 und 2.12, gleichmäßig verteilt.

Zwischen den beiden Segmenten 2.11 und 2.12 ist ein Spalt 16 oder Freiraum vorgesehen, der sich beispielhaft über die gesamte Breite des Tisches 2 erstreckt. Zwischen dem Spalt 16 und der Tischplattenhälfte 2.12 ist ein Vierkant 18 des Tisches 2 eingesetzt, dessen Oberseite bündig zur Oberseite 17.2 der Tischplattenhälfte 2.12 verläuft, d.h., die Oberseite des Vierkants 18 ist koplanar eben zur Oberseite 17.2 der Tischplattenhälfte 2.12. Gegenüberliegend zum Vierkant 18 ist mit Abstand dazu ein weiterer Vierkant 19 in den Spalt 16 eingesetzt, dessen Oberseite sich bündig mit der Oberseite 17.1 der Tischplattenhälfte 2.11 erstreckt, d.h. dessen Oberseite koplanar zur Oberseite 17.1 der Tischplattenhälfte 2.11 ist.

An der Oberseite des Vierkants 18 sind zwei Reihen von Ausströmöffnungen 18.1 ausgebildet, wobei die Ausströmöffnungen 18.1 pro Reihe äquidistant aufeinanderfolgend über die gesamte Breite der Tischplatte 2.1 bzw. der Länge des Vierkants 18 ausgebildet sind. In der Längsrichtung L gesehen sind die beiden Reihen von Ausströmöffnungen 18.1 mit Abstand zueinander und parallel zueinander vorgesehen. Zwischen den beiden Reihen mit Ausströmöffnungen 18.1 ist eine Reihe von Abzugsöffnungen 18.2 über die gesamte Länge des Vierkants 18 verteilt, wobei die einzelnen Abzugsöffnungen 18.2 wiederum äquidistant aufeinanderfolgend angeordnet sind. Im Bereich zwischen jeweils zwei Abzugsöffnungen 18.2 sind somit jeweils zwei Ausströmöffnungen etwa auf einer gedachten Mittenlinie zwischen diesen jeweils zwei Abzugsöffnungen 18.2 angeordnet. In der Längsrichtung L der Tischplatte 2.1 gesehen, liegen die jeweils zwei Ausströmöffnungen 18.1 somit nicht auf einer gemeinsamen, gedachten Linie mit der benachbarten Abzugsöffnung 18.2, sondern die Ausströmöffnungen 18.1 sind versetzt zu den Abzugsöffnungen 18.2. Die Abzugsöffnungen 18.2 und Ausströmöffnungen 18.1 des Vierkants 18 sind über dessen Oberseite gleichmäßig verteilt.

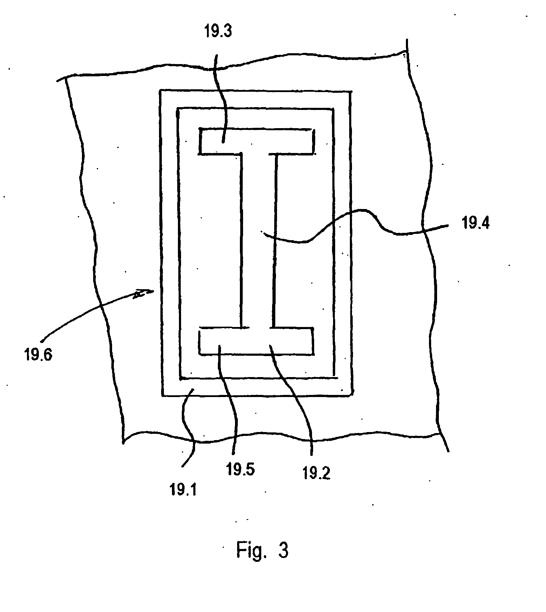

Der Vierkant 19 hat an seiner Oberseite eine Vielzahl von Öffnungsgruppen 19.6 (vgl. Fig. 3), die in einer Reihe äquidistant aufeinanderfolgend über die gesamte Breite B des Tisches 2 bzw. entlang der gesamten Länge des Vierkants 19 angeordnet sind. Jede Öffnungsgruppe 19.6 hat eine Abzugsöffnung 19.2 und eine Ausströmöffnung 19.1, die die Abzugsöffnung 19.2 rahmenförmig oder ringförmig umgibt. Genauer hat in der gezeigten beispielhaften Ausführungsform der Erfindung die Abzugsöffnung 19.2 einen in Längsrichtung des Vierkants 19 sich erstreckenden Längsabschnitt 19.4 und zwei Querabschnitte 19.5 und 19.3, die sich an die Enden des Längsabschnitts 19.4 durchgängig anschließen und sich quer zum Längsabschnitt 19.4 erstrecken. Die Abzugsöffnung 19.2 hat damit einen doppel-T-förmigen Abzugquerschnitt an der Oberfläche bzw. Oberseite des Vierkants 19. Die Ausströmöffnung 19.1 hat einen Austrittsquerschnitt in der Form eines rechteckigen Rahmens, der die Doppel-T-förmige Abzugsöffnung 19.2 durchgängig umrahmt. Insgesamt sind in Fig. 2 elf dieser Öffnungsgruppen 19.6 in Reihe ausgebildet. Die beiden gezeigten Ausbildungen und Anordnungen der Oeffnungen an den Vierkanten 18, 19 sind Alternativen, die bevorzugten Ausführungen entsprechen. Sie gestatten vor allem ein leichtes Aufgleiten des Werkstücks auf den Flächenabschnitt, der in Verschubrichtung auf den Spalt 16 folgt. Bevorzugt werden zwei gleich ausgebildete Vierkante 18, 19 eingesetzt, doch muss dies nicht so sein.

Sämtliche Abzugsöffnungen 14, 18.2 und 19.2 sind fluiddurchgängig mit einem Abzugleitungsnetzwerk 13 z.B. über die Abzugstutzen 14.1 und in den Tischplattenhälften 2.11 und 2.12 ausgebildete Kanäle, die in den Zeichnungen nur andeutungsweise wiedergegeben sind, gekoppelt. Das Abzugleitungsnetzwerk 13 ist wiederum mit der Abzugeinrichtung 11 fluiddurchgängig gekoppelt, die z.B. eine Membranpumpe oder Wasserstrahlpumpe sein kann, und die Gas bzw. Luft von der Oberseite der Tischplatte 2.1 und der Vierkante 18 und 19 abzieht. Zwischen dem Abzugleitungsnetzwerk 13 und der Abzugeinrichtung 11 ist ein Unterdruckregelventil 12 fluiddurchgängig angeordnet, das z.B. mittels einer Mikroprozessoreinrichtung und Software und entsprechender Elektronik gesteuert werden kann.

Die Ausströmöffnungen 15, 18.1 und 19.1 sind mit einem Druckleitungsnetzwerk 8 z.B. über entsprechende Leitungsstutzen und innere Kanäle in den Tischplattenhälften 2.11 und 2.12 und in den Vierkanten 18 und 19 fluidgängig gekoppelt, wobei das Druckleitungsnetzwerk 8 wiederum mit einer Druckerzeugungseinrichtung 6 fluidgängig gekoppelt ist, die z.B. als Kompressor ausgelegt ist, der die druckbeaufschlagte Luft ausgangsseitig bereitstellt. Zwischen dem Druckleitungsnetzwerk 8 und der Druckerzeugungseinrichtung 6 ist ein Druckregelventil 7 fluiddurchgängig eingebaut, das elektronisch gesteuert bzw. geregelt werden kann, wiederum über z.B. eine Mikroprozessoreinrichtung. Dadurch werden Drücke zwischen 0.1 bar und 1.5 bar über dem Umgebungsdruck eingestellt.

Die Lasereinrichtung umfasst z.B. zwei Lasereinheiten 3, 9, die einen Laserstrahl in Richtung der Oberseite des Tisches 2 bzw. der Tischplatte 2.1 zur Bearbeitung einer Oberseite des scheibenförmigen Werkstücks 5 abstrahlt bzw. einen Laserstrahl in Richtung zur Unterseite des scheibenförmigen Werkstücks 5 innerhalb des Spalts 16 zwischen den Tischplattenhälften 2.12 und 2.11 abstrahlt, um die Unterseite des scheibenförmigen Werkstücks 5 mit Laserstrahlen bearbeiten zu können. Der erste Laserstrahl (vgl. Fig. 1) passiert von der Lasereinheit 3 kommend eine Fokussiereinrichtung 4, die den Laserstrahl auf die Oberseite des scheibenförmigen Werkstücks 5 fokussiert, während der zweite Laserstrahl von der weiteren Lasereinheit 9 kommend eine Fokussiereinrichtung 10 passiert, die den Laserstrahl auf die Unterseite des scheibenförmigen Werkstücks 5 zur Bearbeitung fokussiert. Das scheibenförmige Werkstück 5 kann somit sowohl an seiner Unterseite als auch an seiner Oberseite gleichzeitig mit der bevorzugten Ausführungsform der Vorrichtung bearbeitet werden.

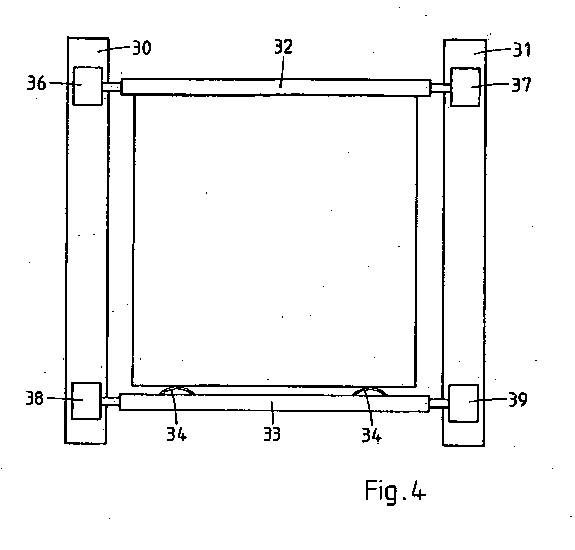

Der Vorschub des scheibenförmigen Werkstücks 5 in der Längsrichtung L des Tisches 2 wird mittels einer Vorschubeinrichtung (Fig. 4) ausgeführt. Sie umfasst eine Linearführung mit zwei an Randleisten 21, die an den gegenüberliegenden Seitenrändern der Segmente 2.11, 2.12 des Tisches 1 angeordnet sind, befestigten Schienen 30, 31, welche quer über den Spalt 16 laufen. Sie können z.B. als Halbrundprofile ausgeführt sein. In der Linearführung ist eine Aufnahme für das Werkstück 5 geführt, welche aus zwei in Längsrichtung beabstandeten unabhängig verschiebbaren Halterungen 32, 33 besteht. Die erste Halterung 32 weist in Längsrichtung wirkende Anschläge für den Rand des Werkstücks auf, die gestatten, es in der Aufnahme genau zu positionieren, während die zweite Halterung 33 eine Andrückvorrichtung trägt, welche z.B. aus zwei bogenförmigen Stahlfedern 34, 35 oder pneumatisch betätigbaren Zylindern besteht und das Werkstück 5 gegen die Anschläge drückt. Jede der beiden Halterungen 32, 33 ist beidseits in den Schienen 30, 31 geführt. Eine Antriebseinrichtung, die Linearmotoren 36, 37 und 38, 39 mit jeweils auf die Schienen 30, 31 abgestimmten Rädern umfasst, welche jeweils die erste Halterung 32 bzw. die zweite Halterung 33 antreiben, dient dazu, die Aufnahme in präzise kontrollierbarer Weise mit dem Werkstück 5 über den Spalt 16 zu schieben, so dass es sukzessive durch die Laserstrahlen 3, 9 bearbeitet werden kann. Die erste Halterung 32 weist ausserdem ein z.B. pneumatisches Element zur Höhenverstellung auf, das es erlaubt, Anschläge zur Auflage des Werkstücks in der Höhe zu verstellen. Damit kann der vordere Rand des Werkstücks 5 auf eine bestimmte Sollhöhe eingestellt werden. Der Rest des Werkstücks 5 wird dann durch Regelung des Luftkissens mittels der Druckregelventile 7, 12 auf die gleiche Höhe eingestellt. Anschliessend wird das Werkstück 5 durch die zweite Halterung 33 kontaktiert und geregelt angedrückt und damit fixiert. Statt der Halterungen 32, 33 kann allerdings auch ein einteiliger höhenverstellbarer Rahmen vorgesehen sein, auf welchen das Werkstück aufgelegt wird.

Der von der Lasereinheit 3 oder 9 ausgesandte Laserstrahl zusammen mit den jeweils zugeordneten Fokussiereinrichtungen 4 bzw. 10 kann über die Breite B des Tisches 2 bzw. des Werkstücks 5 mittels einer Ablenkeinrichtung, z.B. eines Galvanospiegels oder eines verfahrbaren Umlenkspiegels, abgelenkt werden. Während des Vorschubs ist das scheibenförmige Werkstück 5 an dessen Seitenrändern durch Randleisten 21 des Tisches 2 geführt.

Alternativ kann der Vorschub bzw. die Führung des scheibenförmigen Werkstücks berührungsfrei gestaltet werden, z. B. durch entsprechende Steuerung des Luftstroms bzw. durch seitlich angebrachte zusätzliche Gaseinströmöffnungen. Soll die Oberfläche des scheibenförmigen Werkstücks 5 bearbeitet werden, werden die Druckerzeugungseinrichtung 6 und die Abzugeinrichtung 11 in Betrieb gesetzt, wodurch die Druckerzeugungseinrichtung 6 druckbeaufschlagte Luft über das Druckregelventil 7 und das Druckleitungsnetzwerk 8 den Ausströmöffnungen 15 der beiden Tischplattenhälften / Segmenten 2.11 und 2.12 und den Ausströmöffnungen 18.1 des Vierkants 18 und den Ausströmöffnungen 19.1 des Vierkants 19 zuführt. Die druckbeaufschlagte Luft strömt aus den Ausströmöffnungen an der Oberseite der Tischplattenhälften 2.11 und 2.12 und der Vierkante 18 und 19 mit hohem Druck aus. Das scheibenförmige Werkstück 5 wird dann auf den Tisch 2 gelegt und wie beschrieben mit der Vorschubeinrichtung gekoppelt. Das scheibenförmige Werkstück 5 wird dabei über der Oberseite bzw. Oberfläche des Tisches 2 durch das erzeugte Luftkissen angehoben gehalten. Diese Lagerung des scheibenförmigen Werkstücks 5 per Luftkissen geschieht gleichmäßig über die gesamte Tischoberseite bzw. Tischfläche gesehen, da die Ausströmöffnungen 15 und die Abzugsöffnungen 14 bis auf den Spaltbereich gleichmäßig verteilt sind. Da das scheibenförmige Werkstück 5 somit auf einem Luftkissen bzw. einer Gasströmung zwischen der Unterseite des scheibenförmigen Werkstücks 5 und den Oberseiten 17.1 und 17.2 des Tisches 2 gelagert ist, kann es mit der Oberseite des Tisches 2 nicht in Berührung kommen.

Gleichzeitig wird über die Abzugsöffnungen 14, 18.2 und 19.2 an der Oberseite des Tisches 2 von der Abzugeinrichtung 11 über das Abzugleitungsnetzwerk 13 und das Unterdruckregelventil 12 abgezogen, wodurch der Druck der Luftströmung an der Oberseite des Tisches 2 über die Druckdifferenz zwischen der Zufuhrseite und der Abzugseite derart eingestellt werden kann, dass das scheibenförmige Werkstück 5 sicher und ruhig auf einer vorgegebenen Höhe, die der Bearbeitungshöhe des scheibenförmigen Werkstücks 5 entspricht, auf dem erzeugten Luftkissen zwischen dem scheibenförmigen Werkstück 5 und der Oberseite des Tisches 2 gelagert ist. Der Abstand des Werkstücks von der Stützfläche kann etwa auf einen zwischen 0,01 mm und 1 mm, vorzugsweise zwischen 0,05 mm und 0,3 mm liegenden Wert eingestellt werden. Die präzise Einstellung dieser Bearbeitungshöhe ist vor allem dann wichtig, wenn die Bearbeitungsvorrichtung eine Lasereinrichtung ist, da hierbei das Werkstück, bzw. der zu bearbeitende Bereich im Fokus des Lasers gehalten werden muss.

Oft genügt es, die Höhe des Werkstücks 5 ein Mal einzustellen und es wie weiter oben beschrieben zu fixieren.
Sie kann auch einmal überprüft werden, indem eine Messeinrichtung vorgesehen wird mit geeigneten Messmitteln, die die Höhe z.B. interferometrisch oder durch Triangulierverfahren bestimmen und im Spalt 16 oder über den Tisch verteilt angeordnet sind. Im ersteren Fall kann das Werkstück 5 ein Mal über den Spalt 16 verfahren und seine gleichmässige Höhenlage überpüft werden, im letzteren Fall kann die Ueberprüfung rasch durch die verteilten Messmittel erfolgen. Die Höhe des Werkstücks 5 kann auch während der Bearbeitung durch Rückkopplung konstant gehalten werden. Das Werkstück 5 kann mit Hilfe der Messeinrichtung über dem Spalt mit einer Genauigkeit von 50 µm bis 100 µm positioniert werden, wobei die Höhe des Werkstücks durch die Messeinrichtung mit einer Genauigkeit von 1 µm gemessen und danach über einen geeigneten Regelkreis mittels der Druckventile 7, 12 der Gasdruck geregelt wird. Zum Ausgleich kleiner Unebenheiten des Werkstücks 5 kann ausserdem der Fokus des Lasers geregelt werden.

Mit der Vorrichtung der Erfindung können verschiedene Werkstückbearbeitungen unter gleichzeitiger Bearbeitung der Unterseite und auch der Oberseite des Werkstücks 5 durchgeführt werden. Z.B. kann mit dem Laserstrahl Material von der Oberseite bzw. der Unterseite des Werkstücks 5 abgetragen werden, um z.B. Leiterbahnen auf dem Werkstück ausbilden zu können, oder das Werkstück kann mittels Laser markiert oder geritzt werden. Bei einem transparenten Werkstück 5 kann auch etwa eine Beschichtung an der Oberseite von der Unterseite her durch das Werkstück 5 hindurch bearbeitet werden.

Ein Spezialfall des Materialabtrags ist das sogenannte "Laserscribing", bei dem auf einem flächig durchgängig leitend beschichteten dünnen Substrat bestimmte Bereiche elektrisch isoliert werden sollen. Hierzu wird mittels Laser die leitende Schicht entlang einer Linie gezielt abgetragen (die Methode ist als laserablation bekannt) und so die angrenzenden Flächen elektrisch isoliert. Hierzu wird das Werkstück auf einem erfindungsgemässen Tisch auf dem Gas- bzw. Luftpolster berührungsfrei gelagert, über der zwischen den Segmenten 2.11 und 2.12 im Spalt 16 vorgesehenen Behandlungsvorrichtung (Laser) in Längsrichtung L des Tisches 2 hin und herbewegt. Die Bewegung in Querrichtung des Tisches kann durch die Bewegung der Behandlungsvorrichtung im Spalt 16 erzielt werden, in Kombination mit der Längsbewegung lassen sich in bekannter Weise Linien auf dem Substrat beschreiben.

Häufig ist es notwendig, Markierungen auf dem Werkstück vorzusehen, die es erlauben, die Positionierung des Werkstücks relativ zum Tisch bzw. zur Behandlungsvorrichtung festzustellen. Diese Markierungen werden vorteilhaft als Kreuze oder Orientierungslinien ausgeführt. Das Aufbringen der Markierungen kann in einem vorgeschalteten Prozess erfolgen, z. B. durch Aufdrucken oder in einem photolithografischen Belichtungsprozess. Vorteilhaft kann das Markieren aber auch mit der erfindungsgemässen Vorrichtung via Laser erfolgen, z. B. in einem ersten Arbeitsvorgang. Dazu wird es besonders vorteilhaft sein, neben dem Laser als Bearbeitungsvorrichtung einen Detektor für die Markierungen, z.B. eine Mustererkennungsvorrichtung als Messvorrichtung vorzusehen. Dies kann ortsfest an mehreren Stellen im oder am Tisch erfolgen, was es erlaubt, mehrere Markierungen gleichzeitig zu überwachen. In einer Ausführungsform kann die Messvorrichtung aber auch im oder über dem Spalt 16 vorgesehen werden, bevorzugt auf einer Bewegungsvorrichtung wie die Bearbeitungsvorrichtung (Laser) oder sogar kombiniert mit diesem.

Die Positionskontrolle über die Markierungen gestattet es darüberhinaus, die Vorschub- und Führungsvorrichtungen so auszulegen, dass nicht durch sie die Präzision der Positionierung sichergestellt werden muss. Dies wird insbesondere dann notwendig sein, wenn die Lagerung und Führung berührungsfrei bzw. weitgehend berührungsfrei erfolgt.

Die Markierungen sind darüberhinaus wichtig, wenn das Substrat mehrfach beschrieben werden muss, z. B. zwischen verschiedenen Beschichtungsprozessen, die jeweils Lagen von Material auf dem Werkstück ablegen. So kann gewährleistet werden, dass die Orientierung des Werkstücks wiedererkannt wird und die neu zu schreibenden Linien einem vorgegebenen Muster folgt. Die Genauigkeitanforderungen liegen in solchen Fällen bei 5 bis 500 µm. Es Sind jedoch ohne weiteres Genauigkeiten von 10 µm beim Wiederanfahren von Markierungen erreichbar, zumal die Steuerung der Bewegung des Werkstücks noch wesentlich höheren Genauigkleitsanforderungen genügen kann und z.B. 1 µm betragen kann. Die angegebenen Genauigkeiten gelten jeweils für die Positionierung quer zum Spalt wie auch parallel zum Spalt.

Darüberhinaus können die Markierungen in Form z. B. eines Strichcodes auch dazu dienen, das Werkstück zu identifizieren. Somit kann ein individuelles Beschreibungsmuster pro Werkstück vorgesehen werden und die eindeutige Identifizierung des Werkstücks über die Markierung ist gewährleistet. Sind neben einer Bearbeitungsvorrichtung auch Mess- und Prüfvorrichtungen vorgesehen, erlaubt es die Vorrichtung somit auch Prüfling und Messdaten eindeutig zuzuordnen.

In einer anderen Anwendung kann die erfindungsgemäße Vorrichtung auch zum Trennen bzw. Schneiden von scheibenförmigen Werkstücken, z.B. von Glasplatten oder Keramikplatten, verwendet werden. Hier kann das laserinduzierte Schneiden von Platten angewendet werden. Die Vorrichtung der Erfindung schneidet die Platte bzw. das Werkstück 5, indem der Laserstrahl entlang einer Schnittlinie verfahren wird, wobei die Glasplatte entlang der Schnittlinie erwärmt wird, aber nicht geschmolzen wird. Der Erwärmung der Platte entlang der Schnittlinie folgt eine Abkühlung entlang der Schnittlinie durch ein abkühlendes Medium, z.B. einen gekühlten Luftstrahl, wodurch Spannungen entlang der Schnittlinie in der Platte entstehen, die zu einem exakten Bruch der Glasplatte entlang der Schnittlinie führen. Durch die Luftkissenlagerung der Platte bzw. der Glasplatte der Vorrichtung der vorliegenden Erfindung kommt auch bei dem laserinduzierten Schneiden der Platte die Plattenunterseite nicht mit der Tischoberfläche in Berührung, wodurch eine unerwünschte Verschmutzung bzw. ein unerwünschtes Verkratzen oder ein Beschädigen der Plattenunterseite durch die Tischoberfläche vermieden wird.

Der Tisch kann auch mehrere aufeinanderfolgende Spalte aufweisen, die z.B. durch Vierkante voneinander getrennt sind und in denen jeweils eine Bearbeitungsvorrichtung angeordnet ist. So können mehrere Bearbeitungsvorgänge gleichzeitig ablaufen.

## Patentansprüche

1. Tisch (2) mit einer ebenen Stützfläche zur Aufnahme eines Werkstücks (5), wobei die Stützfläche aus mindestens zwei Flächenabschnitten besteht, die in einer Längsrichtung aufeinanderfolgen und durch einen quer zur Längsrichtung verlaufenden Spalt (16) getrennt sind und über die Flächenabschnitte jeweils Ausströmöffnungen (15) zur Zuleitung von Druckgas zwecks Herstellung eines Gaspolsters zwischen dem jeweiligen Flächenabschnitt und der Unterseite des Werkstücks (5) verteilt sind, sowie mit einer Vorschubeinrichtung für das Werkstück, welche geeignet ist, dasselbe in Längsrichtung über den Spalt (16) zu verschieben und mit einer Bearbeitungsvorrichtung zum Bearbeiten des Werkstücks (5), **dadurch gekennzeichnet, dass** die Bearbeitungsvorrichtung unterhalb des Spaltes (16) angeordnet ist und die Vorschubeinrichtung eine den Spalt (16) in Längsrichtung querende Linearführung mit zwei parallelen, quer zur Längsrichtung beabstandeten Schienen (30, 31) umfasst sowie eine Aufnahme für das Werkstück (5) mit einer ersten Halterung (32) und einer in Längsrichtung von derselben beabstandeten zweiten Halterung (33), welche jeweils in beiden Schienen (30, 31) geführt sind und eine Antriebsvorrichtung, welche geeignet ist, die Aufnahme entlang der Linearführung zu verschieben.

2. Tisch (2) nach Anspruch 1, **dadurch gekennzeichnet, dass** die erste Halterung (32) in Längsrichtung wirksame Anschläge für das Werkstück (5) aufweist und die zweite Halterung (33) eine Andrückvorrichtung, die geeignet ist, das Werkstück (5) gegen die Anschläge zu drücken.

3. Tisch (2) nach Anspruch 1 oder 2, **dadurch gekennzeichnet, dass** die Antriebsvorrichtung jeweils mindestens einen mit der ersten Halterung (32) und mit der zweiten Halterung (33) verbundenen Linearmotor (36, 37; 38, 39) umfasst.

4. Tisch (2) nach einem der Ansprüche 1 bis 3, **dadurch gekennzeichnet, dass** er eine Mustererkennungsvorrichtung zum Erkennen von Referenzmarken auf dem Werkstück (5) und ihrer Lage umfasst.

5. Tisch (2) nach einem der Ansprüche 1 bis 4, **dadurch gekennzeichnet, dass** er eine weitere Bearbeitungsvorrichtung zum Bearbeiten des Werkstücks (5) umfasst, die oberhalb des Spaltes (16) angeordnet ist.

6. Tisch (2) nach einem der Ansprüche 1 bis 5, **dadurch**
**gekennzeichnet, dass** die Bearbeitungsvorrichtung mindestens eine gegen den Spalt (16) gerichtete Lasereinheit (3, 9) umfasst.

7. Tisch (2) nach Anspruch 6, **dadurch gekennzeichnet, dass** der Fokus der Lasereinheit (3, 9) in der Höhe verstellbar ist.

8. Tisch (2) nach einem der Ansprüche 1 bis 7, **dadurch gekennzeichnet, dass** die Ausströmöffnungen (15) jeweils im wesentlichen gleichmässig über die Flächenabschnitte verteilt sind.

9. Tisch (2) nach einem der Ansprüche 1 bis 8, **dadurch gekennzeichnet, dass** die Ausströmöffnungen (15) mindestens zum Teil rund sind und vorzugsweise jeweils einen zwischen 0,05 mm und 10 mm, insbesondere zwischen 0,1 mm und 2 mm liegenden Durchmesser aufweisen.

10. Tisch (2) nach einem der Ansprüche 1 bis 9, **dadurch gekennzeichnet, dass** über die Flächenabschnitte Abzugsöffnungen (14) zum Abziehen von Druckgas verteilt sind.

11. Tisch (2) nach Anspruch 10, **dadurch gekennzeichnet, dass** die Abzugsöffnungen (14) mindestens zum Teil als zum Spalt (16) annähernd parallele, in Längsrichtung gleichmässig über die Flächenabschnitte verteilte Abzugsschlitze ausgebildet sind.

12. Tisch (2) nach Anspruch 11, **dadurch gekennzeichnet, dass** die Abzugsschlitze jeweils einer Zickzacklinie folgen.

13. Tisch (2) nach einem der Ansprüche 10 bis 12, **dadurch gekennzeichnet, dass** mindestens beidseits des Spaltes (16) Abzugsöffnungen (18.2, 19.2) angeordnet sind, welche jeweils von einer einen geschlossenen Schlitz bildenden Ausströmöffnung (18.1, 19.1) umgeben sind.

14. Tisch (2) nach Anspruch 13, **dadurch gekennzeichnet, dass** die Abzugsöffnung (19.2) jeweils als etwa Doppel-T-förmiger Schlitz ausgebildet ist und die sie umgebende Ausströmöffnung (19.1) als einen rechteckigen Rahmen bildender Schlitz.

15. Verfahren zur Bearbeitung eines Werkstücks (5) auf einem Tisch (2) nach einem der Ansprüche 1 bis 14, **dadurch gekennzeichnet, dass** das Werkstück (5) in die Aufnahme eingespannt und dann mit derselben über den Spalt (16) verschoben und gleichzeitig von der unterhalb des Spaltes (16) angeordneten Bearbeitungsvorrichtung durch den Spalt (16) bearbeitet wird.

16. Verfahren nach Anspruch 15, **dadurch gekennzeichnet, dass** es Bearbeitung mittels eines Laserstrahls umfasst.

17. Verfahren nach Anspruch 16, **dadurch gekennzeichnet, dass** das Werkstück (5) für den Laserstrahl transparent ist und eine an der Oberfläche desselben angeordnete Schicht bearbeitet wird.

## Claims

1. Table (2) having a flat support surface for holding a workpiece (5), where the support surface consists of at least two surface sections which follow one another in a longitudinal direction and are separated by a gap (16) running transversely to the longitudinal direction and in each case outflow orifices (15) for feeding compressed gas for producing a gas cushion between the respective surface section and the bottom of the workpiece (5) are distributed over the surface sections and with a a feed apparatus for the workpiece (5) which is suitable for displacing the same across the gap (16) and with a processing device for processing the workpiece (5), **characterized in that** the processing device is arranged below the gap (16) and the feed apparatus comprises a linear guide traversing the gap (16) in the longitudinal direction with two parallel rails (30, 31) which are a distance apart transversely to the longitudinal direction as well as a receptacle for the workpiece (5) with a first holder (32) and a second holder (33) which is a distance away therefrom in the longitudinal direction, which holders are each guided in both rails (30, 31), and a drive device suitable for displacing the receptacle along the linear guide.

2. Table (2) according to Claim 1, **characterized in that** the first holder (32) has stops for the workpiece (5) which are effective in the longitudinal direction and the second holder (33) has a pressure device which is suitable for pressing the workpiece (5) against the stops.

3. Table (2) according to Claim 1 or 2, **characterized in that** the drive device comprises in each case at least one linear motor (36, 37; 38, 39) connected to the first holder (32) and to the second holder (33).

4. Table (2) according to any of Claims 1 to 3, **characterized in that** it comprises a pattern recognition device for recognizing reference marks on the workpiece (5) and their positions.

5. Table (2) according to any of Claims 1 to 4, **characterized in that** it comprises a processing device for processing the workpiece (5) which is arranged above the gap (16).

6. Table (2) according to any of Claims 1 to 5, **characterized in that** the processing device comprises at least one laser unit (3, 9) directed towards the gap (16).

7. Table (2) according to Claim 6, **characterized in that** the focus of the laser unit (3, 9) is adjustable in height.

8. Table (2) according to any of Claims 1 to 7, **characterized in that** the outflow orifices (15) are distributed in each case substantially uniformly over the surface sections.

9. Table (2) according to any of Claims 1 to 8, **characterized in that** the outflow orifices (15) are at least partly round and preferably have in each case a diameter between 0.05 mm and 10 mm, in particular between 0.1 mm and 2 mm.

10. Table (2) according to any of Claims 1 to 9, **characterized in that** take-off orifices (14) for removing compressed gas are distributed over the surface sections.

11. Table (2) according to Claim 10, **characterized in that** the take-off orifices (14) are at least partly in the form of take-off slits approximately parallel to the gap (16) and distributed in the longitudinal direction uniformly over the surface sections.

12. Table (2) according to Claim 11, **characterized in that** the take-off slits each follow a zigzag line.

13. Table (2) according to any of Claims 10 to 12, **characterized in that** take-off orifices (18.2, 19.2) which in each case are surrounded by an outflow orifice (18.1, 19.2) forming a closed slit are arranged at least on both sides of the gap (16).

14. Table (2) according to Claim 13, **characterized in that** the take-off orifice (19.2) is formed in each case as an approximately double-T-shaped slit and the outflow orifice (19.1) surrounding it is formed as a slit forming a rectangular frame.

15. Method for processing a workpiece (5) on a table (2) according to any of Claims 1 to 14, **characterized in that** the workpiece (5) is clamped in the receptacle and then displaced therewith over the gap (16) and at the same time is processed through the gap (16) by the processing device arranged below the gap (16).

16. Method according to Claim 15, **characterized in that** it comprises processing by means of a laser beam.

17. Method according to Claim 16, **characterized in that** the workpiece (5) is transparent to the laser beam and a layer arranged on the surface thereof is processed.

## Revendications

1. Table (2) comportant une surface d'appui plane destinée à recevoir une pièce (5), la surface d'appui étant constituée d'au moins deux sections de surface qui se suivent l'une l'autre dans une direction longitudinale et sont séparées par un intervalle (16) s'étendant transversalement à la direction longitudinale et des orifices d'échappement (15) répartis sur les sections de surface, servant à amener du gaz comprimé en vue de produire un coussin de gaz entre la section de surface respective et la face inférieure de la pièce (5), ainsi qu'un dispositif d'avance de la pièce, qui est apte à déplacer ladite pièce dans la direction longitudinale en traversant l'intervalle (16) et un dispositif d'usinage destiné à usiner la pièce (5), **caractérisée en ce que** le dispositif d'usinage est disposé au-dessous de l'intervalle (16) et le dispositif d'avance comprend un guidage linéaire traversant l'intervalle (16) dans la direction longitudinale avec deux rails (30, 31) parallèles écartés l'un de l'autre transversalement à la direction longitudinale, ainsi qu'un logement pour la pièce (5) avec un premier support (32) et un deuxième support (33) écarté du premier dans la direction longitudinale, lesquels sont guidés chacun dans les deux rails (30, 31), et un dispositif d'entraînement qui est apte à déplacer le logement le long du guidage linéaire.

2. Table (2) selon la revendication 1, **caractérisée en ce que** le premier support (32) présente des butées pour la pièce (5) agissant dans la direction longitudinale et le deuxième support (33) un dispositif de pression qui est apte à presser la pièce (5) contre les butées.

3. Table (2) selon la revendication 1 ou 2, **caractérisée en ce que** le dispositif d'entraînement comprend au moins un moteur linéaire (36, 37 ; 38, 39) relié respectivement au premier support (32) et au deuxième support (33).

4. Table (2) selon l'une des revendications 1 à 3, **caractérisée en ce qu'**elle comprend un dispositif d'identification de modèle servant à identifier des marques de référence sur la pièce (5) et leur position.

5. Table (2) selon l'une des revendications 1 à 4, **caractérisée en ce qu'**elle comprend un autre dispositif d'usinage destiné à usiner la pièce (5) et disposé au-dessus de l'intervalle (16).

6. Table (2) selon la revendication 1 à 5, **caractérisée en ce que** le dispositif d'usinage comprend au moins une unité laser (3, 9) orientée vers l'intervalle (16).

7. Table (2) selon la revendication 6, **caractérisée en ce que** le foyer de l'unité laser (3, 9) est réglable en hauteur.

8. Table (2) selon l'une des revendications 1 à 7, **caractérisée en ce que** les orifices d'échappement (15) sont répartis essentiellement régulièrement sur chaque section de surface.

9. Table (2) selon l'une des revendications 1 à 8, **caractérisée en ce que** les orifices d'échappement (15) sont ronds au moins en partie et présentent chacun de préférence un diamètre compris entre 0,05 mm et 10 mm, en particulier entre 0,1 mm et 2 mm.

10. Table (2) selon l'une des revendications 1 à 9, **caractérisée en ce que** des orifices d'évacuation (14) sont répartis sur les sections de surface pour évacuer du gaz comprimé.

11. Table (2) selon la revendication 10, **caractérisée en ce que** les orifices d'évacuation (14) sont réalisés au moins en partie sous la forme de fentes d'évacuation qui sont approximativement parallèles à l'intervalle (16) et réparties régulièrement sur les sections de surface dans la direction longitudinale.

12. Table (2) selon la revendication 11, **caractérisée en ce que** les fentes d'évacuation suivent respectivement une ligne en zigzag.

13. Table (2) selon l'une des revendications 10 à 12, **caractérisée en ce que** des orifices d'évacuation (18.2, 19.2), qui sont entourés chacun par un orifice d'échappement (18.1, 19.1) formant une fente fermée, sont disposés au moins de part et d'autre de l'intervalle (16).

14. Table (2) selon la revendication 13, **caractérisée en ce que** l'orifice d'évacuation (19.2) est réalisé sous la forme d'une fente approximativement en double T et l'orifice d'échappement (19.1) qui l'entoure sous la forme d'une fente formant un cadre rectangulaire.

15. Procédé d'usinage d'une pièce (5) sur une table (2) selon l'une des revendications 1 à 14, **caractérisé en ce que** la pièce (5) est fixée dans le logement puis déplacée avec celui-ci en traversant l'intervalle (16), et en même temps est usinée à travers de l'intervalle (16) par le dispositif d'usinage disposé au-dessous de l'intervalle (16).

16. Procédé selon la revendication 15, **caractérisé en ce qu'**il comprend l'usinage au moyen d'un faisceau laser.

17. Procédé selon la revendication 16, **caractérisé en ce que** la pièce (5) est transparente au faisceau laser et qu'une couche disposée sur la surface de celle-ci est usinée.
